# EUROPEAN PATENT APPLICATION

(11) **EP 1 752 480 A1**
(43) Date of publication of application: **14.02.2007**
(21) Application number: 06014727.9
(22) Date of filing: 14.07.2006
(51) Int. Cl.: C08G 12/00, C08G 12/12, C08G 12/26, C08G 12/32, H01L 51/00

(54) **Polymerizable dielectric material**

(30) Priority: 12.08.2005 EP 05017655
(71) Applicant: Merck Patent GmbH, 64293 Darmstadt (DE)
(72) Inventor: Sparrowe, David, Bournemouth BH6 3BB (GB); McCulloch, Iain, Southampton SO53 4LG (GB); Heeney, Martin, Southampton SO14 6TQ (GB); Shkunov, Maxim, Southampton SO16 6SX (GB)

(57) **Abstract**

The present invention relates to a novel polymerizable dielectric material comprising crosslinkable organic amine derivatives and crosslinked polymers obtained thereof, which are useful for the manufacture of dielectric layers of electronic devices, to a novel method for the manufacture of dielectric layers of electronic devices, and to electronic devices obtained by said method.

## Description

### Field of Invention

The present invention relates to a novel polymerizable dielectric material comprising crosslinkable organic amine derivatives and to crosslinked polymers obtained thereof, which are useful for the manufacture of dielectric layers of electronic devices. Furthermore, the invention relates to a novel method for the manufacture of dielectric layers of electronic devices, and to electronic devices obtained by said method.

### Background and Prior Art

A promising approach for large scale, low cost manufacture of organic based integrated circuits is that fabrication steps are carried out by solution processing. This allows the possibility for roll-to-roll processing, where large areas can be coated and printed at high speed. Key requirement for an insulator compatible with this technique is a sufficient solubility in a process appropriate solvent to ensure that the solution wets and coats the surface, and that the film formed is coherent. This requires optimisation of the solution rheology and evaporation rates. In addition, for a multilayer structure, it is essential that the solvent used in deposition of each layer does not dissolve or swell the layer on which it is in contact with, thus preventing poor interfaces and interlayer diffusion. As each layer is applied via solution, then a solvent with an incompatible solubility parameter to the previous layer is required, sometimes referred to as an orthogonal solvent. This solvent parameter latitude can be significantly widened if the previous layer can undergo a chemical process such as crosslinking. By crosslinking the film in situ, shorter potentially mobile molecular units are tethered into an immobile network.

In a common device structure, the insulator is applied onto the semiconductor surface. Most semiconductors contain aliphatic chains, which impart solubility and often improve morphology. However, the consequence of this chemical structure is that the aliphatic groups are thermodynamically driven to the semiconductor surface, rendering it hydrophobic and of very low energy. This makes wetting the surface during solution application of the insulator an important consideration.

Working devices require an insulator which exhibits high electrical resistivity, has an optimum dielectric constant as defined by the geometry of the device, and is chemically inert during the lifetime of the device. High electronic bandgap organic materials provide excellent electrical insulation, whereas the dielectric constant of the film is a function of the electronic polarizability, and is frequency dependant. The electronic polarizability can be increased by addition of polar groups.

EP 1 416 004 A1, the entire disclosure of which is incorporated into this application by reference, discloses a formulation comprising crosslinkable organic amine derivatives, optionally further multifunctional compounds capable of reacting with the amines, and a polymerization initiator. EP 1 416 004 A1 further discloses the corresponding crosslinked polymer products, like for example melamine resins, and their use for the manufacture of dielectric layers of electronic devices.

However, although this crosslinkable insulator works well for some multilayer devices there is still a question over operational hysteresis that is sometimes seen with these type of devices. This hysteresis and some other related problems are thought to come from mobile ions within the semiconductor or insulator layers. One way to overcome these problems is obviously to purify the materials. However, purification of the insulator can result in a change in its fundamental properties, especially when the polymerization catalyst or initiator, which is required to crosslink the insulator, is present during purification of the polymer.

It is an aim of this invention to provide improved materials and methods for the preparation of dielectric layers which do not have the disadvantages of known dielectric materials and preparation methods. A further aim of this invention is to provide formulations comprising crosslinkable amine derivatives which are especially suited for the manufacture of dielectric layers of electronic devices. A further aim of this invention is to provide improved methods for the manufacture of dielectric layers of electronic devices, which is especially suited for the production of a high number of pieces and/or large areas. Additional aims of this invention concern organic electronic devices. Other aims of the present invention are immediately evident to a person skilled in the art from the following detailed description.

The inventors of the present invention have found that these aims can be achieved by using materials and methods as claimed the present invention. Thus, the inventors have found that, in crosslinkable dielectric formulations for use as insulating layers in electronic devices as disclosed in prior art, incorporation of a polymerization catalyst, for example an acidic reagent, can be the source of mobile ion impurities, which cause undesired hysteresis in the final electronic device. The inventors have further found out that these problems can be overcome by using a polymeric or polymer bound thermal acid as polymerization initiator. The polymer bound thermal acid is of high molecular weight, therefore it will not be mobile within the insulator and, once reacted, does not significantly alter the properties of the insulator or device. An additional advantage of using a thermal acid is that the temperature at which the crosslinking occurs can be lowered.

Besides dielectric layers for electronic devices, the materials and methods according to this invention can also be used for other polymer products or applications. For example, they can be used for the preparation of optical polymer films for liquid crystal displays films, where free radical polymerisation is disadvantageous. In such a case cationic polymerisation can be used without increasing the conductivity of the LC films.

### Definition of Terms

The term electronic device encompasses all devices and components with electronic, preferably microelectronic, including electrooptical functionality, like e.g. resistors, diodes, transistors, integrated circuits, light emitting diodes and electrooptical displays. In particular, the term electronic device includes organic electronic devices, i.e. all electronic devices and components in which at least one functionality, like e.g. conduction, semiconduction and/or light emission, is realized by a polymer and/or an organic material. Examples of such organic electronic devices are organic light emitting diodes (OLEDs), organic field effect transistors (OFETs) and devices which contain a number of such components, like polymeric integrated circuits, e.g. containing OFETs, and active matrices, e.g. comprising thin film transistors (TFTs) of liquid crystal displays (LCDs) and other displays.

The term dielectric layer or material means a layer or material exhibiting very low or even non-conducting electrical properties, in particular with a resistivity greater or equal than 10⁺⁸ Ωcm.

The term layer as used in this application includes coatings on a supporting substrate or between two substrates, as well as self-supporting, i.e. freestanding, films that show more or less pronounced mechanical stability and flexibility. The layer may be flat or may be varyingly shaped in any of the three dimensions, including patterned.

The term substrate as used in this application relates to the part of the organic device that the amine mixture is coated onto.

The term substrate is also used for the starting material used as a base for the device. This material is typically silicon wafer, glass or plastic (e.g. PET foil). In a typical transistor device the source and drain electrode will have already been structured onto the surface (lithography, thermal evaporation or printing methods). On top of this structure a surface energy modification layer or an alignment layer is optionally deposited, then the semiconductor (e.g. polyhexylthiophene), the insulator, i.e. the amine mixture, and finally the gate electrode is arranged.

### Summary of the Invention

The invention relates to a formulation comprising
- one or more crosslinkable organic amine derivatives which are capable of forming a crosslinked polymer with itself and/or with each other and/or with one or more additional multifunctional compounds in a polymerization or crosslinking reaction,
- one or more polymeric or polymer bound initiators which are capable of initiating said polymerization or crosslinking reaction.

The invention further relates to a crosslinked polymer product obtainable by crosslinking said formulation.

The invention further relates to the use of said formulation and crosslinked polymer as dielectric or insulating material in electronic and electrooptical devices.

The invention further relates to a method of manufacturing a dielectric layer of an electronic device using said formulation or polymer.

The invention further relates to dielectric layers obtainable by said method, and to electronic, optical or electrooptical devices comprising said dielectric layers.

Preferred electronic, optical or electrooptical components or devices include, without limitation, an organic field effect transistor (OFET), thin film transistor (TFT), component of integrated circuitry (IC), radio frequency identification (RFID) tag, organic light emitting diode (OLED), electroluminescent display, flat panel display, backlight, photodetector, sensor, logic circuit, memory element, capacitor, photovoltaic (PV) cell, charge injection layer, Schottky diode, planarising layer, antistatic film, conducting substrate or pattern, photoconductor, and electrophotographic element.

### Brief Description of the Drawings

**Figure 1** illustrates the preparation of a transistor device.
**Figure 2** shows a transistor device comprising a dielectric layer according to the present invention.
**Figure 3** shows the threshold characteristics of a transistor device according to the present invention and of a transistor device according to prior art.

### Detailed Description of the Invention

When using a crosslinkable formulation according to the present invention comprising a polymeric or polymer bound thermal acid as polymerization initiator, which has high molecular weight, the initiator will not be mobile within the final crosslinked polymer material. Thus, after polymerization the initiator does not significantly alter the properties of the polymer material or of an insulator layer or device comprising it.

Especially preferred is a formulation comprising
- 50 to 99.5 % by weight of a component A,
- 0 to 50 % by weight, preferably 0.5 to 50 % by weight of a component B, and
- 0 to 10 % by weight of a component C,
wherein
A: comprises one or more organic amine derivative as described above and below, preferably comprising two or more identical or different groups of the subformula I as defined above,
B: comprises one or more multifunctional compounds, being capable of reacting with at least one compound of component A to form a crosslinked polymer, and
C: comprises at least one initiator as described above and below, for the polymerization of the component A or the components A and B.

Another object of the present invention is a crosslinked polymer material obtainable by polymerization of a formulation as described above and below.

Another object of this invention is a process for the manufacture of a dielectric layer of an electronic device comprising the steps
a) preparing a substrate which optionally comprises one or more layers or patterns of materials with insulating, semiconductive, conductive, electronic and/or photonic functionalities,
b) forming a thin layer of a formulation comprising one or more crosslinkable organic amine derivatives as defined in the foregoing and in the following onto said substrate or onto defined regions of said substrate, and
c) initiating the polymerization of said formulation.

An additional object of this invention refers to an electronic device obtainable by the process according to the present invention.

Furthermore, an object of this invention refers to an electronic device comprising a crosslinked polymer material according to this invention as a dielectric.

Suitable crosslinkable organic amines for component A are disclosed in EP 1 416 004 A1. Especially preferred are amine derivatives comprising two or more identical or different groups of the subformula I 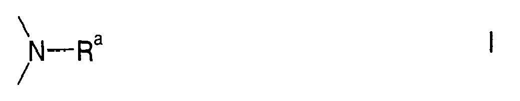 wherein
- R^{a}: is H, -[(CR'R'')ᵥ-CO]ᵣ-R''', -[(CR'R'')ᵥ-O-]ᵣR''' or -(CR'R'')ᵥ-NHZ,
- R', R'', R''': are independently of each other H, an alkyl group with 1 to 12 C-atoms or an alkenyl group with 2 to 12 C-atoms, which may be substituted by halogen,
- Z: is H or a protective group,
- v: is 0 or greater or equal to 1, and
- r: is greater or equal to 1, wherein if v is 0, then r is 1.

Amine derivatives comprising groups of the subformula I show advantageous solution properties with respect to rheology and intercoat adhesion and are therefore especially suited for the manufacture of dielectric layers of electronic devices. This finding also holds for their crosslinked polymer products, obtainable by crosslinking said amine derivative with itself or with at least one multifunctional compound. In addition these derivatives can effectively wet a low energy hydrophobic surface, especially surfaces of organic semiconducting materials. Furthermore, it has been observed that by either self-crosslinking the amine derivative according to the invention or crosslinking it with at least one multifunctional compound advantageous changes in electric, viscoelastic behaviour and densification, i.e. improved flexibility, elasticity, durability, solvent resistance and/or insulator characteristics can be achieved.

The amine derivatives according to the present invention possess functional groups that are capable of undergoing chemical reactions either with themselves or a co-component, especially with a multifunctional compound as defined in the following, to form a crosslinked polymer network. The chemical reaction is controllable, in that at least at room temperature, i.e. 20°C, or below the amine derivative can be stored with essentially no chemical reaction occuring. The chemical reaction can be initiated by e.g. rising the temperature, altering the pH, exposing to electromagnetic or particle radiation or to reactive compounds. Those amine derivatives are preferred, which, cross-linked with themselves or one or more multifunctional compounds, result in stable dielectric films of high resistivity, especially a resistivity greater or equal than 10⁺⁸ Ωcm.

Preferably the amine derivative according to the invention comprises two or more groups of the subformula I as defined above wherein at least one of the groups R^{a} comprises an alkyl group with 1 to 12 C-atoms or an alkenyl group with 2 to 12 C-atoms, which may be substituted by halogen.

Furthermore the amine derivative according to the invention comprises preferably one or more -OH groups. Most preferably it comprises two or more groups of the subformula I as defined above wherein at least one of the groups R^{a} is -[(CR'R'')ᵥ-O-]ᵣ-H and R', R'', v and r are as defined above.

According to a preferred embodiment of the invention, the amine derivative is selected from the following group of formulae I.1 to I.3 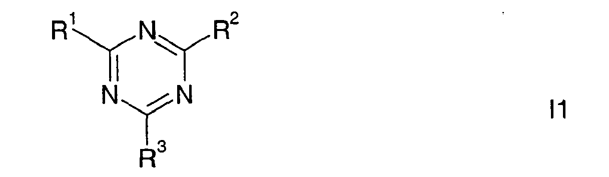 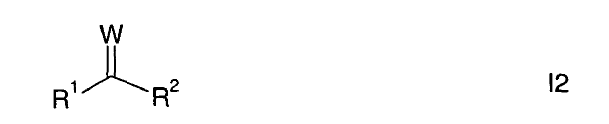 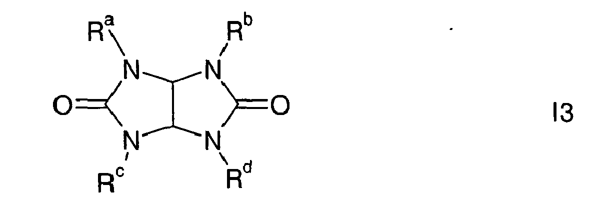 wherein
- R¹, R², R³: are independently of each other a group of formula II

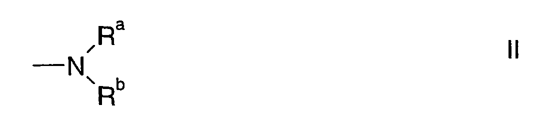

- R^{a}, R^{b}, R^{c}, R^{d}: are independently of each other H, -[(CR'R'')ᵥ-CO]ᵣ-R''', -[(CR'R'')ᵥ-O-]ᵣ-R''' or -(CR'R'')ᵥ-NHZ,
- R', R'', R''': are independently of each other H, an alkyl group with 1 to 12 C-atoms or an alkenyl group with 2 to 12 C-atoms, which may be substituted by halogen,
- Z: is H or a protective group,
- v: is 0 or greater or equal to1,
- r: is greater or equal to 1, wherein if v is 0, then r is 1,
- W: is O or S,
- R³: may, in addition to the foregoing meaning, be an alkyl, cycloalkyl, aryl or alkylaryl group, which is optionally substituted by halogen.

In the following the groups, substituents and indices R¹, R², R³, R^{a}, R^{b}, R^{c}, R^{d}, R', R'', R''', Z, v, r and n have the above given meaning unless stated otherwise.

It is emphasized that each group, substituent and index occuring twice or more in one of the foregoing or following formulae may have identical or different meanings.

By the choice of the substituents R^{a} and R^{b}, the physical and chemical properties of the amine derivative, of its polymerizable mixture and of the resulting polymer can be influenced in order to meet the requirements for the manufacture of dielectric layers of organic electronic devices. Furthermore, the processing of a polymerizable mixture comprising such an amine derivative and its polymerization characteristic is influenced by the substituents R^{a} and R^{b}.

Those amine derivatives selected from the group of formulae I1 to 13 are preferred wherein at least one of the groups R¹, R², R³ and/or of the groups R^{a}, R^{b}, R^{c}, R^{d} comprises an alkyl group with 1 to 12 C-atoms or an alkenyl group with 2 to 12 C-atoms, which may be substituted by halogen.

Z is H or a protective group of an amino function, like e.g. formyl, tosyl, acetyl, trifluoroacetyl, methoxy, ethoxy, tert.-butoxy, cyclopentyloxy as well as phenoxycarbonyl, carbobenzyloxy and p-nitrobenzyloxy.

The index v is preferably 1 to 6, most preferably 1 or 2.

The index r is preferably 1 to 4, most preferably 1 or 2.

Those derivatives selected from the group of formulae I.1 and 1.2 are preferred, wherein one, two or three of the groups R¹, R², R³ are a group of formula IIa 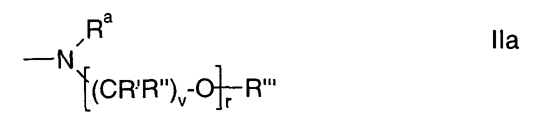 wherein R^{a}, R', R'', R''', v and r have the meaning given above.

According to the preferred embodiment of formula IIa, the following variants themselves or the combination of two or more of these variants are preferred:
- two or three of the groups R¹, R², R³ of formulae 11 and 12 have independently of each other the meaning according to formula IIa.
- R''' is an alkyl group with 2 to 12 C-atoms, preferably with 3 to 12 C-atoms, which may be substituted by halogen.
- R''' is an alkyl group with 2 to 8 C-atoms, preferably 3 to 8 C-atoms, most preferably with 3, 4, 5 or 6 C-atoms, wherein one, more or all H-atoms may be substituted by halogen, preferably by F or Cl.
- r is 1 or 2, preferably 1.
- v is 1, 2, 3 or 4, preferably 1.
- R' and R'' are H.
- R^{a} is H or comprises at least one -OH group.
- R^{a} is -[(CR'R'')ᵥ-O-]ᵣ-H, wherein R', R'', v and r are as defined above, preferably R' and R'' are H, v is preferably 1, 2, 3 or 4, most preferably 1 or 2 and r is preferably 1 or 2, most preferably 1.
- R^{a} is -CH₂-OH.

Furthermore those derivatives selected from the group of formulae I1 and I2 are preferred, wherein one, two or three of the groups R¹, R², R³ are independently of each other a group of formula IIb 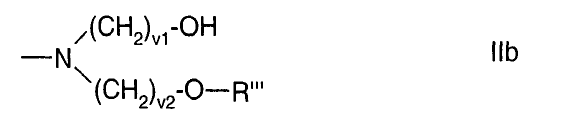 wherein
- v1: is 0, 1, 2, 3 or 4, preferably 1,
- v2: is 1, 2, 3 or 4, preferably 1,
- R''': is preferably H or an alkyl group with 1 to 12 C-atoms, preferably 2 to 8 C-atoms, wherein one, more or all H-atoms may be substituted by halogen, preferably by F or CI.

Beside the preferred condition, that at least one of the groups R¹, R², R³ and/or of the groups R^{a}, R^{b}, R^{c}, R^{d} comprises an alkyl group with 1 to 12 C-atoms or an alkylene group with 2 to 12 C-atoms, which may be substituted by halogen, it has been found, that
- if at least one of R^{a}, R^{b} is H, a fast cure response and a good film hardness is achieved.
- if at least one of R^{a}, R^{b} is -OH or -CH₂OH, a mixture comprising this amine derivative shows advantageous rheology properties.
- if at least one of R^{a}, R^{b} is -(CH2)ᵥ-O-R''', wherein v ≥ 1 and R''' is an alkyl group, in particular with 2 or more C-atoms, a more flexible dielectric layer is obtainable.
- if at least one of R^{a}, R^{b} is -(CH₂)ᵥCO-R''', wherein v ≥ 1 and R''' is an alkyl group, in particular with 2 or more C-atoms, relatively low viscosities, improved flow, leveling and wetting properties and a good intercoat adhesion of a polymerizable mixture comprising the inventive amine derivative is obtainable. Furthermore, the mixture shows a high formulation stability and the resulting dielectric layer has a good flexibility.

The amine derivatives according to this invention may possess beside N-H, N-CH₂-OH and/or N-CH₂-O-Alkyl functionalities also -CO- groups.

In a preferred embodiment of the present invention, the formulation comprises two or more crosslinkable organic amine derivatives.

Amine derivatives which exhibit not only one kind of substituent, but a combination of different substituents, especially those mentioned in the foregoing, and/or combinations of two or more amine derivatives according to the invention are especially preferred, because they do better allow to meet the requirements of the processing techniques for the manufacture of dielectric layers of organic electronic devices and the requirements of the dielectric layers themselves.

Using the formulation according to the invention, even hydrophobic surfaces, in particular with surface energies lower than 20 mN/cm, can be wetted and coated, yielding a coherent film, which can be cured. Thus, also patterns or layers of materials with low and very low surface energy, like e.g. of semiconductive polymers with aliphatic chains to improve their solubility, can be coated with the inventive material.

Those amine derivatives are preferred as component A which were described in the foregoing, especially an amine derivative or a combination of 2, 3 or more amine derivatives according to formula I.1 and/or I.2, wherein one, two or three of the substituents R¹, R², R³ are independently of each other of formula II, in particular of formula IIa and/or IIb.

In a preferred embodiment, melamine-formaldehyde resins and urea-formaldehyde resins are used as component A. Commercially available melamine-formaldehyde resins using e.g. the brandname ®Cymel are commercially available from CYTEC INDUSTRIES INC., West Paterson, NJ 07424, USA. A commercially available urea-formaldehyde resin is UI20-E from CYTEC INDUSTRIES INC., West Paterson, NJ 07424, USA.

In another preferred embodiment of the present invention, the formulation comprises one or more additional multifunctional compounds (component B), which are capable of reacting with at least one component of A to form a crosslinked polymer. The multifunctional compounds are advantageously chosen such that the resulting mixture exhibits good rheological properties with respect to the employed manufacture techniques of thin dielectric layers. Furthermore, the mechanical and electrical properties of the resulting dielectric layer can be influenced by the choice of the multifunctional compound. In addition, the water uptake of the resulting amine polymer can be minimised by employing multifunctional compounds with at least one hydrophobic group, like e.g. aliphatic alkyl chains.

Preferably at least one multifunctional compound of component B is an organic compound with at least two functional groups from the class consisting of -OH, -NH₂, -COOH and their reactive derivatives, being capable of reacting with at least one component of A to form a crosslinked polymer. Preferred multifunctional compounds are aliphatic, cycloaliphatic and aromatic dioles, polyoles, diacids, polyacids, diamines, polyamines and their reactive derivatives. Reactive derivatives are advantageously such derivatives, from which the desired functional group can be set free under appropriate reaction conditions, like e.g. by elimination of a protective group. Classes of preferred multifunctional compounds are alkanedioles with 2 to 12 C-atoms, polyhydroxyalkyl (meth)acrylates, poly (meth)acrylic acids, polyols and optionally substituted phenol formaldehyde condensation copolymers. Examples of such compounds are 1,4-butanediol, polyhydroxyethyl methacrylate, polyacrylic acid, polyurethane polyols, polyethylene imine, polyvinyl phenol as well as cresol formaldehyde condensation copolymer. A commercially available polyurethane polyol is K-Flex diol DU 320 from KING INDUSTRIES (2741 EZ Waddinxveen, The Netherlands). A commercially available cresol formaldehyde condensation copolymer is Novolak AZ 520D from Clariant GmbH, 65926 Frankfurt am Main, Germany.

The formulation according to the present invention further comprises one or more polymeric or polymer bound polymerization initiators (component C), for the polymerization of the component A or the components A and B. Suitable initiators are acids or bases and compounds which set free an acid or a base under appropriate reaction conditions, like e.g. by heat or actinic radiation.

The term "polymeric or polymer bound" includes compounds with an initiator group that is itself part of a polymer backbone or is attached to a polymer backbone. The polymeric initiator preferably has a molecular weight from 500 to 1,000,000.

Especially suitable and preferred are soluble, thermally activated acids, in particular polymeric sulfonic acids like poly-4-styrene sulfonic acid. An advantage of using a thermal acid is that the temperature at which the crosslinking occurs can be lowered. However, other polymeric initiators that are known to the person skilled in the art can also be used.

Preferred values of the lower limit of the formulation are:
- component A: 60 % by weight, most preferably 75 % by weight.
- component B: 2 % by weight, most preferably 5 % by weight.
- component C: 0 % by weight, most preferably 0.5 % by weight.

Preferred values of the upper limit of the formulation are:
- component A: 98 % by weight, most preferably 95 % by weight.
- component B: 40 % by weight, most preferably 25 % by weight.
- component C: 5 % by weight, most preferably 2 % by weight.

The above given % by weight values are related to the total weight of the components A, B and C.

Preferably the formulation according to the invention additionally comprises a component D in an amount of from 0.5 to 50000 % by weight related to the total weight of the components A, B and C, wherein D is a solvent or a mixture of two or more solvents, being capable of dissolving the components A, B and/or C.

In this case the term dissolving means that a solution, emulsion or suspension of the components A, B and/or C can be produced, optionally with the aid of one or more emulsifiers or surfactants.

The solvents or solvent mixtures are advantageously compatible with solution coating techniques. Preferred solvents are aliphatic or cycloaliphatic ketones, alcohols and ethers, like e.g. cyclohexanone, butanone, iso propyl alcohol (IPA), butanol, ethyl lactate, propylene glycol methyl ether acetate (PGMEA) and propylene glycol methoxy propanol (PGME), as well as mixtures thereof. The solvent or solvent mixture is preferably chosen to stabilize the resulting mixture, which also increases its shelf life.

In addition to component D, the formulation according to the invention may comprise at least one surfactant as a component E to adjust the surface energy of the formulation and the resultant film in order to obtain desired wetting, rheology and adhesion to the substrate and consecutive layers. A further advantage of an added surfactant is a decrease of the water uptake into the resulting amine polymer layer. The surfactant is preferably a nonionic surfactant, like e.g. polyoxyethylene, polyols, siloxanes, pluoronics and tweens.

Preferred values of the lower limit of the formulation are:
- component D: 10 % by weight, most preferably 100 % by weight,
- component E: 0 % by weight, most preferably 0.05 % by weight, and
preferred values of the upper limit of the formulation are:
- component D: 10000 % by weight, most preferably 5000 % by weight,
- component E: 2 % by weight, most preferably 0.5 % by weight,
wherein the above given % by weight values are related to the total weight of the components A, B and C.

In another preferred embodiment of the present application, the formulation according to the invention additionally comprises superfine ceramic particles as a component F.

The superfine ceramic particles F are contained in the formulation in an amount of from 0 to 80 % by weight, related to the total weight of components A, B and C.

The ceramic particles should be less than 200 nm in average diameter, since that is typically the maximum desired thickness for the insulating layer. Preferably, the particles are less than 100 nm to provide for easy dispersion within the polymeric matrix, and more preferably, about 50 nm in average size.

The particles can be formed from any suitable material which can be formed into particles having a high dielectric, including, for example, high dielectric constant ferroelectric ceramic material including, but not limited to, lead zirconate, barium zirconate, cadmium niobate, barium titanate, and titanates and tantalates of strontium, lead, calcium, magnesium, zinc and neodymium, and solid solutions thereof. By the term ceramic "solid solution" is meant a ceramic system of two or more components in which the ceramic components are miscible in each other. In addition, ceramic materials useful in the invention include barium zirconium titanate (BZT), barium strontium titanate (BST), barium neodymium titanate, lead magnesium niobate, and lead zinc niobate. Each particle can be formed from a single one or a combination of these materials.

The particles included in the layer can all be uniform, or can vary in material composition and/or size. In addition, ceramic materials useful in the invention may be modified by additives including, but not limited to, oxides of zirconium, bismuth, and niobium. Preferably, the ceramic particles comprise barium titanate.

The components of the formulation according to the invention are also chosen to yield good rheology properties, i.e. a viscosity high enough to form a coherent film in a solution coating process and a viscosity low enough to be filterable and spreadable. Preferred viscosity ranges of the mixture are from 300 to 100000 mPa·s.

If in the compounds and components described above and below a substituent, in particular R', R'', R''', R¹, R², R³, R^{a}, R^{b}, R^{c}, R^{d} is an alkyl group, this may be straight-chain or branched. It is preferably straight-chain, has 1 to 12 carbon atoms and accordingly is preferably methyl, ethyl, propyl, butyl, pentyl, hexyl, heptyl, octyl, nonyl, decyl, undecyl or dodecyl. Fluorinated alkyl is preferably CᵢF₂ᵢ₊₁, wherein i is an integer from 1 to 12, in particular CF₃, C₂F₅, C₃F₇, C₄F₉, C₅F₁₁, C₆F₁₃, C₇F₁₅, C₈F₁₇, C₉F₁₉, C₁₀F₂₁, C₁₁F₂₃ or C₁₂F₂₅.

Cycloalkyl preferably denotes a cyclic aliphatic group containing, e.g. 3 to 7 C-atoms such as cyclopropyl, cyclopentyl and cyclohexyl.

Aryl preferably denotes an aromatic hydrocarbon with 5 to 15 C-atoms, which may be substituted by one or more heteroatoms O, S and/or N, constituting 1, 2 or 3 rings, which may be fused to each other. The most preferred meaning of aryl is phenyl.

Alkylaryl preferably contains 5 to 15 C-atoms in the aryl portion and contains 1 to 12 C-atoms in the alkylene portion, for example, benzyl, phenethyl and phenpropyl.

Halogen is F, Cl, Br or I, preferably F or Cl. In the case of polysubstitution halogen is particularly F.

In the following a process for the manufacture of a dielectric layer of an electronic device according to the invention is described.

In step a) of the process a substrate, which optionally comprises one or more layers or patterns of materials with insulating, semiconductive, conductive, electronic and/or photonic functionalities, is prepared. A number of well-known processing techniques for the manufacture of conventional electronic as well as organic electronic devices, which are preferred according to this invention, are available to a person skilled in the art. For example, the structure of organic electronic devices, the materials and techniques for their manufacture are described in detail in the literature cited in the introduction. The processing is usually done by employing solutions of the organic and/or polymeric materials, like e.g. by methods described below. The molecules of the resulting film may be aligned in order to achieve anisotropic charge carrier mobility and/or optical dichroism. The organic film is preferably cured, e.g. in defined regions by radiation using a mask. The exposed regions undergo a change in their physical and/or chemical properties, like e.g. their conductance or solubility. Unexposed regions may be removed due to their higher solubility. By this procedure several layers, which may be patterned, with different electronic functionality may be built on top of each other. Advantageously orthogonal solvents are applied, as described in the introduction, in order not to impair to the previously built layer or pattern. Beside this other patterning methods, like e.g. microlithography, stamping or micromoulding, may be employed.

In step b) of the process a thin layer of a formulation comprising one or more amine derivatives as defined in the foregoing is formed onto the substrate or onto defined regions of the substrate. The formulation is preferably applied as a solution, whereby advantageous solvents and their mixtures are described above. Preferred techniques of forming a thin layer allow low cost processing of large areas and/or a high number of substrates. Examples are spin-coating, moulding, like micro-moulding in capillaries, and printing techniques, like screen-printing, ink-jet printing and microcontact printing. Reel-to-reel fabrication processes are especially preferred. These and other processing techniques are described e.g. by Z. Bao, Adv. Mater. 2000, 12, 227-230, Z. Bao et al., J. Mater. Chem. 1999, 9, 1895-1904 and the literature cited therein. As mentioned above, the rheology properties of the employed amine derivative mixture can be adjusted in a wide range to meet the requirements of the film forming technique by the choice of the components of the mixture, especially of the substituents of the amine derivative and optionally of the multifunctional component, and of their contents.

In step c) the polymerization of the formulation of said thin layer is initiated. Depending on the nature of the components of the amine derivative mixture and the optionally employed initiator, the polymerization is initiated for example by rising the temperature, altering the pH, exposing to electromagnetic or particle radiation or to reactive compounds. The polymerization reaction is usually a polycondensation of the amine derivatives and optionally the multifunctional components, whereby for example water or alcohols are set free. The resulting polymer materials may be polymers, copolymers or graft polymers, which are referred to just as polymers in the foregoing and in the following.

The component D or at least a major part of the solvents is removed during and/or after the performance of step c). But it is also possible to remove solvents while and/or after the polymerizable mixture is formed onto the substrate, before step c) is carried out.

The resulting thin layer of the amine polymer has preferably a thickness of 0.01 to 50 µm, most preferably of 0.1 to 10 µm. The amine polymer material shows preferably a resistivity greater or equal than 10⁺⁸ Ωcm, more preferably greater or equal than 10⁺¹⁰ Ωcm and most preferably greater or equal than 10⁺¹¹ Ωcm. The resulting dielectric constant of the material is preferably greater or equal 4 and most preferably in the range from 4 to 6.

The thin layer may optionally be patterned after the polymerization step. Suitable techniques are known by a person skilled in the art, in particular in the field of microelectronics and microtechnology. Examples of such techniques are etching, lithography, including photo-, UV- and electron-lithography, laser writing, stamping and embossing. Furthermore the layer may also be patterned by polymerizing only defined regions of the polymerizable amine mixture. Polymerization in defined regions may be accomplished for example by using a patterned mask and electromagnetic or particle radiation to initiate the polymerization. The unpolymerized regions of the amine derivative mixture may be removed due to their higher solubility compared to the cured regions.

The formation of the dielectric amine polymer layer may be the last or, usually, an intermediate step in the fabrication of the electronic device. Thus one or more further steps, including steps a) and/or b) and c), may follow the process described above. For example one or more further layers or patterns of materials with insulating, semiconductive, conductive, electronic and/or photonic properties may be applied onto the resulting dielectric layer.

Electronic devices obtainable by the process according to the invention and electronic devices comprising the inventive amine polymer material as a dielectric are also objects of this invention. Preferred devices are microelectronic and/or organic electronic devices and components. Examples are thin film transistors, OFETs, OLEDs, large area driving circuits for displays, in particular LCDs, photovoltaic applications and low-cost memory devices, such as smart cards, electronic luggage tags, ID cards, credit cards and tickets.

The polymer amine material according to the invention can be used as a dielectric, including insulator material, in these devices. For example, the polymer amine material is used as a dielectric layer in an OFET between the semiconductive material, being contacted with the source and the drain electrode, and the gate material. Furthermore, the inventive amine polymer material may also be used as an insulator material, to insulate conducting parts of the electronic device. Thus it may be used as a substrate, on top of which conducting and/or semiconducting materials are deposited, and/or as an insulating material to cover layers or patterns with electronic functionality, thus protecting them from short-circuits or oxidation.

The complete disclosure of all applications, patents and publications mentioned hereinbefore and hereinafter is introduced into this application by way of reference.

From the foregoing description, one skilled in the art can easily ascertain the essential characteristics of this invention, and without departing from the spirit and scope thereof, can make various changes and modifications of the invention to adapt it to various usages and conditions.

The following examples are set forth to further illustrate the present invention and should not be construed as limiting the spirit or scope of the invention.

### Examples

### General procedure for a dielectric formulation comprising two part resin and one part hardner:

A resin (for example a commercially available Cymel® resin from Cytec Inc.) is mixed into suitable formulation, which is determined by the nature of the device being fabricated, such as construction, geometry, required thickness, durability, stability, process flow, etc.. The polymer thermal acid is then added just before spin coating. This step is done because, if the polymeric acid is added and not used relatively quickly (within a few hours), the viscosity of the formulation increases. An increase in viscosity is undesired because it would affect the coating thickness and could change the properties of the device.

The resin is spin coated at desired spin speed and acceleration in order to give the desired film thickness. Then the film is baked at high temperature, e.g. 100°C, depending on required speed of crosslinking.

### Example 1

The following polymerizable amine mixture according to this invention is prepared. The content in % by weight is related to the total weight of all components.

### 1. Resin formulation

| Component | Compound | Content [%] |
|---|---|---|
| A | Melamine-formaldehyde resin, UI20-E | 35.0 |
| B | None | None |
| | | |
| D | Butan-1-ol | 48.4 |
| | butan-2-one | 16.0 |

### Hardner formulation

| Component | Compound | Content [%] |
|---|---|---|
| C | Poly(4-styrenesulfonic acid) | 1.6 |
| D | Butan-1-ol | 98.4 |

The individual components are stable over time.
These components when mixed are stable and homogeneous for several hours. They show a low to medium viscosity. Their rheology properties are very good for applying coating techniques, like for example the coating of surfaces of glass or polyhexylthiophene, which is an organic semiconductor.

### 2. Preparation of amine polymer materials

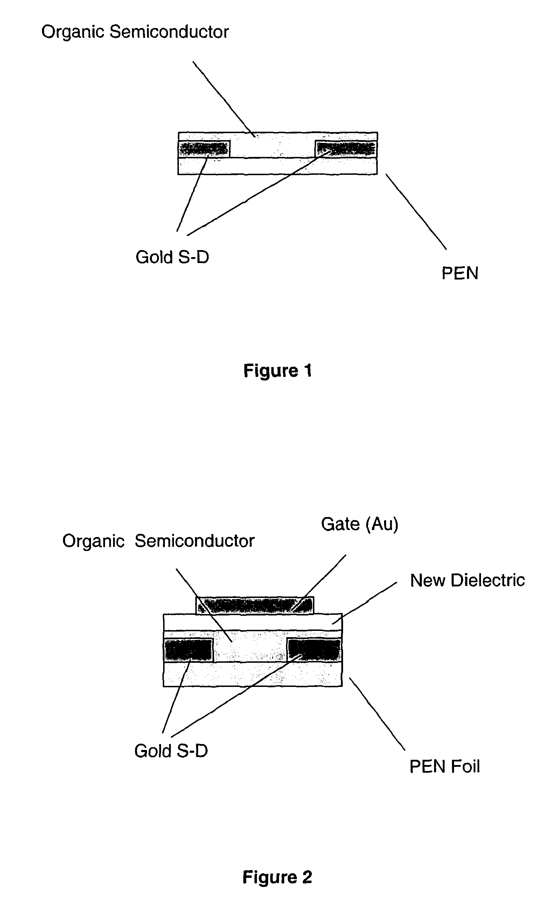

Based on the polymerizable amine mixture the amine polymer materials are prepared. The resin and hardner are thoroughly mixed together in the ratio of 2 to 1 respectively, this mixture is put onto a flat substrate which in this case is PEN foil, evaporated gold source and drain contacts and on top of this spin coated organic semiconductor layer as shown in **Figure 1** which then is spread over the substrate by spin-coating (increasing from 0 to 3000 rpm over a period of 1 second and then held at 3000 rpm for 1 minute). The polymerization and crosslinking is performed by heating the substrate at 100°C for a duration of 1 hour in an air atmosphere. The resulting amine polymer layer has a thickness of about 1 micron.

Using the polymerizable mixture as defined in the foregoing, amine polymer layers are prepared according to the procedure described above. The surfaces of all polymer layers are very flat, hard, but not brittle and exhibit an excellent cohesion. There is no evidence of pinhole formation.

### Example 2 - Use example

**Figure 2** shows a transistor device to test the dielectric formulation according to the present invention (which is not to scale). Typically several transistors are made on each substrate.

### Process to make transistor:

A special PEN foil (available from Dupont Teijin films) with planarising layer is used as the device substrate. This substrate is cleaned in IPA before use. Gold source and drain contacts are evaporated onto the PEN foil by vacuum evoporation through a shodow mask. The gold is typically 50nm thick. The distance between source and drain is typically 130microns. The organic semiconductor is deposited in a glove box via spin coating and typically a 100nm film is obtained. The dielecric formulation is deposited via spin coating so that a thickness of around 1 micron is obtained. The whole device is baked at approx. 100°C to croslink the dielectric. The final step is to evaporate 50nm layer of gold which will act as the device's gate.

A transistor device T1 is prepared as described above, using a dielectric layer as described in example 1 (with a polymeric acid).

For comparison purpose a transistor device T2 is prepared in the same manner as described above, using the same resin and solvent formulation but with a non-polymeric acid initiator,which is paratoluene sulfonic acid,for the dielectric layer.

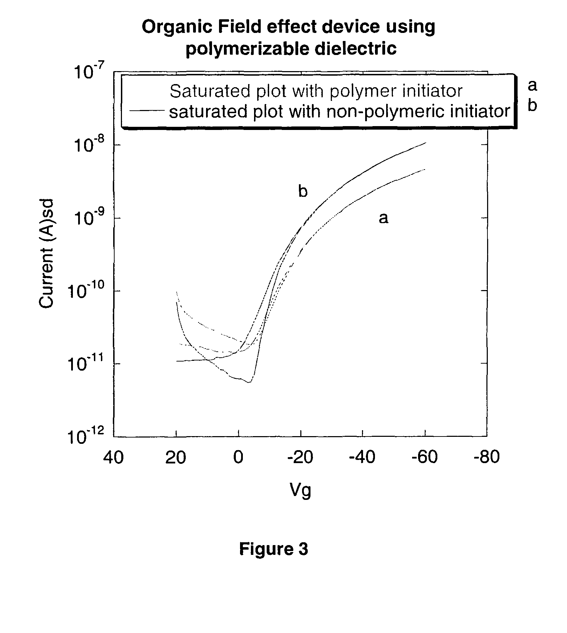

The threshold characteristics of the two transistors are shown in **Figure 3** (curve a = T1, curve b = T2). The plot for T1 shows the same threshold voltage in both reverse and forward scans (approx. +4V). The plot for T2 shows a different threshold voltage on forward scan as compared to the reverse scan (approximate hysteresis of 6V).

## Claims

1. Formulation comprising
- one or more crosslinkable organic amine derivatives, which are capable of forming a crosslinked polymer with itself and/or with each other and/or one or more additional multifunctional compounds in a polymerization or crosslinking reaction,
- one or more polymeric or polymer bound initiators which are capable of initiating such a polymerization or crosslinking reaction.

2. Formulation according to claim 1, **characterized in that** the amine derivative comprises two or more identical or different groups of the subformula I 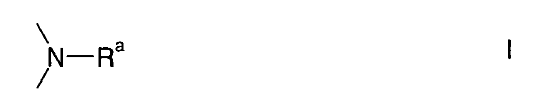 wherein
R^{a} is H, -[(CR'R'')ᵥ-CO]ᵣ-R''', -[(CR'R'')ᵥ-O-]ᵣ-R''' or -(CR'R'')ᵥ-NHZ,
R', R'', R''' are independently of each other H, an alkyl group with 1 to 12 C-atoms or an alkenyl group with 2 to 12 C-atoms, which may be substituted by halogen,
Z is H or a protective group,
v is 0 or greater or equal to 1, and
r is greater or equal to 1, wherein if v is 0, then r is 1.

3. Formulation according to claim 2, **characterized by** one or more amine derivatives comprising two or more groups of the subformula I as defined in claim 2 wherein at least one of the groups R^{a} comprises an alkyl group with 1 to 12 C-atoms or an alkenyl group with 2 to 12 C-atoms, which may be substituted by halogen.

4. Formulation according to claim 2 or 3, **characterized by** one or more amine derivatives comprising two or more groups of the subformula I as defined in claim 2 wherein at least one of the groups R^{a} is -[(CR'R'')ᵥ-O-]ᵣ-H and R', R'', v and r are defined as in claim 2.

5. Formulation according to at least one of claims 1 to 4, **characterized by** one or more amine derivatives selected from the following group of formulae I1 to I3 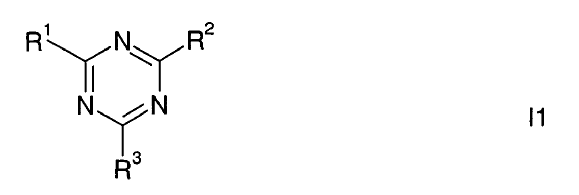 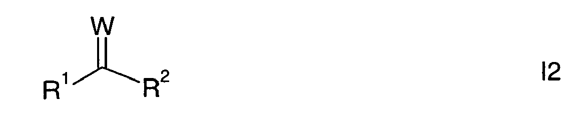 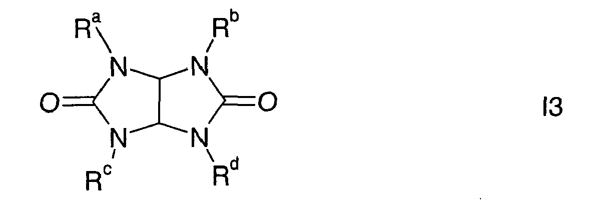 wherein
R¹, R², R³ are independently of each other a group of formula II 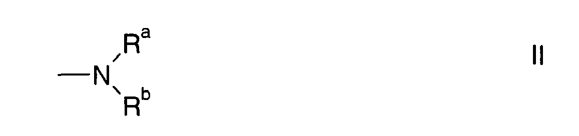
R^{a}, R^{b}, R^{c}, R^{d} are independently of each other H, -[(CR'R'')ᵥ-CO]ᵣ-R''', -[(CR'R'')ᵥ-O-]ᵣ-R''' or -(CR'R'')ᵥ-NHZ,
R', R'', R''' are independently of each other H, an alkyl group with 1 to 12 C-atoms or an alkenyl group with 2 to 12 C-atoms, which may be substituted by halogen,
Z is H or a protective group,
v is 0 or greater or equal to 1,
r is greater or equal to 1, wherein if v is 0, then r is 1,
W is O or S,
R³ may, in addition to the foregoing meaning, be an alkyl, cycloalkyl, aryl or alkylaryl group, which is optionally substituted by halogen.

6. Formulation according to claim 5, **characterized by** one or more amine derivatives selected from the group of formulae I.1 to I.3 as defined in claim 5 wherein at least one of the groups R¹, R², R³ and/or of the groups R^{a}, R^{b}, R^{c}, R^{d} comprises an alkyl group with 1 to 12 C-atoms or an alkenyl group with 2 to 12 C-atoms, which may be substituted by halogen.

7. Formulation according to claim 5 or 6, **characterized by** one or more amine derivatives selected from the group of the formulae I.1 and I.2 as defined in claim 5 wherein one, two or three of the groups R¹, R², R³ are independently of each other a group of subformula IIb 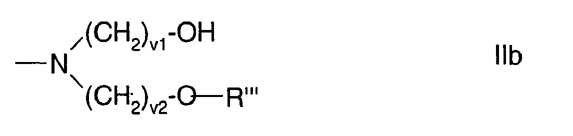 wherein
v1 is 0, 1, 2, 3 or 4,
v2 is 1, 2, 3 or 4,
R''' is an alkyl group with 1 to 12 C-atoms, wherein one, more or all H-atoms may be substituted by halogen.

8. Formulation comprising
50 to 99.5 % by weight of a component A,
0 to 50 % by weight, of a component B, and
0 to 10 % by weight of a component C,
wherein
component A comprises one or more organic amine derivatives as defined in at least one of claims 2 to 7,
component B comprises one or more multifunctional compounds, being capable of reacting with at least one compound of A to form a crosslinked polymer, and
component C comprises one or more polymeric or polymer bound initiators for the polymerization of the component A or the components A and B.

9. Formulation according to at least one of claims 1 to 8, **characterized in that** the multifunctional compounds of component B are selected from organic compounds with at least two functional groups from the class consisting of -OH, -NH₂, -COOH and their reactive derivatives, being capable of reacting with at least one component of A to form a crosslinked polymer.

10. Formulation according to at least one of claims 1 to 9, **characterized in that** the polymeric or polymer bound initiator is selected from soluble, thermal activated acids with a molecular weight of 500 or more.

11. Formulation according to at least one of claims 1 to 10, **characterized in that** the polymeric or polymer bound initiator is poly-4-styrene sulfonic acid.

12. Formulation according to at least one of claims 1 to 11, **characterized in that** it additionally comprises a component D in an amount of from 0.5 to 50000 % by weight related to the total weight of components A, B and C, wherein D is a solvent or a mixture of two or more solvents, being capable of dissolving the components A, B and/or C.

13. Formulation according to at least one of claims 1 to 12, **characterized in that** it additiionally comprises superfine ceramic particles as a component F.

14. Formulation according to claim 13, **characterized in that** the superfine ceramic particles F are contained in the polymerizable amine mixture in an amount of from 0 to 80 % by weight, related to the total weight of components A, B and C.

15. Crosslinked polymer material obtainable by polymerization of a formulation according to at least one of claims 1 to 14.

16. Use of a formulation or corsslinked polymer according to at least one of claims 1 to 15 in an organic field effect transistor (OFET), thin film transistor (TFT), component of integrated circuitry (IC), radio frequency identification (RFID) tag, organic light emitting diode (OLED), electroluminescent display, flat panel display, backlight, photodetector, sensor, logic circuit, memory element, capacitor, photovoltaic (PV) cell, charge injection layer, Schottky diode, planarising layer, antistatic film, conducting substrate or pattern, photoconductor or electrophotographic element

17. Process for the manufacture of a dielectric layer of an electronic device comprising the steps
a) preparing a substrate which optionally comprises one or more layers or patterns of materials with insulating, semiconductive, conductive, electronic and/or photonic functionalities,
b) forming a thin layer of a formulation as defined in at least one of claims 1 to 14 onto said substrate or onto defined regions of said substrate, and
c) initiating the polymerization of the formulation of said thin layer.

18. Electronic device comprising a polymer material according to claim 15 as a dielectric.

19. Electronic device obtainable by a process according to claim 17.
